(19) Europäisches Patentamt
European Patent Office
Office européen des brevets

(11) **EP 2 660 047 A1**

(12) **EUROPEAN PATENT APPLICATION**
published in accordance with Art. 153(4) EPC

(43) Date of publication:
06.11.2013 Bulletin 2013/45

(51) Int Cl.:
**B32B 27/00** (2006.01)

(21) Application number: 11854066.5

(22) Date of filing: 28.12.2011

(86) International application number:
PCT/JP2011/080471

(87) International publication number:
WO 2012/091122 (05.07.2012 Gazette 2012/27)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 28.12.2010 JP 2010293740
28.12.2010 JP 2010293752

(71) Applicant: Mitsubishi Plastics, Inc.
Tokyo 100-8252 (JP)

(72) Inventors:
• AKAIKE, Osamu
Ushiku-shi
Ibaraki 300-1201 (JP)
• NINOMIYA, Naoya
Ushiku-shi
Ibaraki 300-1201 (JP)
• MITSUKURA, Yumi
Ushiku-shi
Ibaraki 300-1201 (JP)
• AYUTA, Mitsuhiro
Nagahama-shi
Shiga 526-8660 (JP)

(74) Representative: Ter Meer Steinmeister & Partner
Me/bk
Mauerkircherstrasse 45
81679 München (DE)

(54) **LAMINATED MOISTURE-PROOF FILM**

(57) The present invention relates to a moisture-proof laminated film having, on the substrate thereof, an inorganic thin film layer and having, on the inorganic thin film layer, a plastic film via a polyurethane adhesive satisfying the following requirement (1), or the following requirements (1) and (2). The moisture-proof laminated film keeps excellent moisture-proofness and interlayer strength even after exposed to high temperature condition. (1) $-0.1 \leq E21 \leq +0.5$. (2) $-0.3 \leq E21 \leq +0.3$. (In the above formulae, E21 indicates $(E2 - E1)/E2$, and E23 indicates $(E2 - E3)/E2$. E1, E2 and E3 each mean the tensile storage elastic modulus of the adhesive under specific conditions.)

**Description**

Technical Field

The present invention relates to a moisture-proof laminated film for use for electronic devices such as solar cells, etc., in particular to an excellent moisture-proof laminated film, which, even after it is exposed to high-temperature conditions when incorporated in electronic devices such as solar cell modules or the like, still keeps moisture-proofness and interlayer strength.

Background Art

A moisture-proof film, which has an inorganic thin film of silicon oxide or the like formed on the surface of a plastic film substrate, is laminated with any other plastic film and has been used in various wrapping or packaging applications. Recently, such a moisture-proof film has become used in new applications as substrate films or vacuum insulation materials for use in liquid-crystal display devices, solar cells, electromagnetic wave shields, touch panels, organic electroluminescence (EL) devices, organic TFT, organic semiconductor sensors, organic luminescence devices, electronic papers, film  capacitors, inorganic EL devices, color filters, etc.
In these applications, the moisture-proof laminated film has become required to satisfy tougher capabilities, and an excellent moisture-proof film, of which the moisture-proofness worsens little even after exposed to high-temperature conditions for a long period of time, has become developed.
For example, in PTL 1, an adhesive layer is provided on a moisture-proof film, of which the substrate is a biaxially-stretched polyester film, by the use of a polyurethane adhesive (main ingredient Takelac A511/curing agent Takenate A50 = 10/1 solution), and the film is subsequently laminated with other films to produce a solar cell surface protective material, and evaluated for the barrier properties and the interlayer strength thereof after an accelerated test at 85°C and at 85% humidity for 1000 hours, and a proposal for preventing the two characteristics from degrading is made therein.
In PTL 2, a PVF film is stuck to a moisture-proof film, of which the substrate is a biaxially-stretched polyester film like in the above, by the use of a two-component curable polyurethane adhesive, and evaluated for the moisture-proof performance and the interlayer strength thereof before and after a pressure cooker test (PCT) (severe environment test at high temperature and high pressure, 105°C, 92 hours), and a proposal for preventing the characteristics from degrading is made therein.

Citation List

Patent Literature

   PTL 1: JP-A 2009-188072
   PTL 2: JP-A 2009-49252

Summary of Invention

Technical Problem

For example, when a surface protective material is incorporated in a solar cell, the surface protective material is laminated with other parts and integrated through vacuum lamination at a temperature of from 130°C to 180°C for a period of from 10 minutes to 40 minutes. However, heretofore, nothing has been disclosed relating to the influence of the vacuum lamination process condition in production of electronic devices such as solar cells or the like, on the moisture-proofness of the surface protective material; and even though the method described in any of the above-mentioned patent literature is employed, it has heretofore been impossible to prevent the moisture-proof performance and the interlayer strength from degrading.
In particular, in use for solar cell protective materials for compound-type power generation device solar cell modules that are required to have high-level moisture-proofness and glass-free solar cell modules that are required to have flexibility, and also in use for electronic papers and others, the influence of the vacuum lamination process thereon must be taken into consideration, and it is also required to prevent the moisture-proofness and the interlayer strength thereof from being degraded after the acceleration test. However, in the conventional inventions, in fact, any concrete proposal has not as yet been made at all for realizing a moisture-proof laminated film capable of still keeping high-level moisture-proofness even after exposed to high-temperature conditions in consideration of the effect of the vacuum lamination process that may actually damage the surface protective materials.

Specifically, an object of the present invention is to provide a moisture-proof laminated film capable of keeping excellent moisture-proofness and interlayer strength even after exposed to high-temperature conditions. Solution to Problem

The present inventors have assiduously studied and, as a result, have found that, when an adhesive, of which the storage elastic modulus change at a temperature corresponding to the vacuum lamination condition for the moisture-proof laminated film (130°C to 180°C) and for a period of time corresponding thereto (10 to 40 minutes) (hereinafter the temperature and the time are referred to as thermal lamination condition) falls within a specific range, is used and when an inorganic thin film layer and a plastic film are laminated via the adhesive, then the resulting laminate can satisfy both prevention of moisture-proofness degradation and prevention of interlayer strength degradation, and have completed the present invention.

The moisture-proof laminated film for use for solar cell protective materials and others is produced according to a dry lamination process. In dry lamination, an adhesive diluted with a solvent is applied to a plastic film to a predetermined thickness thereon, and dried at a temperature, for example, falling within a range of from 100°C to 140°C to evaporate away the solvent thereby forming an adhesive layer on the plastic film. Subsequently, a moisture-proof film is stuck to the plastic film with the inorganic thin film side of the former kept facing to the adhesive side of the latter, and then cured at a predetermined temperature to produce a moisture-proof laminated film. For curing, for example, the laminate is kept at a temperature of from 30°C to 80°C for a period of from 1 day to 1 week.

In case where the moisture-proof laminated film is used as the protective member for solar cells or the like, if desired, a surface protective layer having a predetermined layer configuration may be provided on one side or both sides of the moisture-proof laminated film according to a dry lamination, extrusion lamination or the like process similarly to the above.

In the case of the solar cell surface protective member, the produced surface protective member is heat-sealed and integrated with a solar cell element and a encapsulant through vacuum lamination.

The vacuum lamination process is carried out at a temperature much higher than the adhesive drying temperature and the curing temperature, falling within a range of from 130°C to 180°C, and therefore the process degrades or changes the structure, the composition and others of the adhesive layer of the moisture-proof laminated film, and the change in the adhesive layer imparts stress to the inorganic thin film layer to generate defects in the deposited layer, thereby degrading the moisture-proofness of the film. In particular, in the case of a moisture-proof film having high-level moisture-proofness, the degradation of the moisture-proofness of the film owing to the stress propagation from the adhesive layer is remarkable. This is because even slight defects in the inorganic thin film layer and between the substrate and the inorganic thin film layer could have a significant influence on the high-level moisture-proofness of the film.

From the above, the present inventors have found that, when the tensile storage elastic modulus change E21 that indicates the structure change in the adhesive layer after predetermined heat treatment under a lamination condition corresponding to a vacuum lamination temperature satisfies a specific requirement (1), then the stress propagation to the inorganic thin film layer in the vacuum lamination process can be relaxed and the moisture-proofness and the interlayer strength can be thereby prevented from being degraded, or that is, both the two can be kept high.

Further, the present inventors have found that, in addition to the above-mentioned requirement (1), when the tensile storage elastic modulus change E23 that indicates the structure change in the adhesive layer before and after a high-temperature high-humidity test under an accelerated test condition to be given to the moisture-proof laminated film after predetermined heat treatment satisfies a specific requirement (2), then the stress propagation to the inorganic thin film layer during the vacuum lamination process and in the subsequent accelerated test can be relaxed and the moisture-proofness and the interlayer strength can be thereby prevented from being degraded, or that is, both the two can be kept high.

Specifically, the first embodiment of the present invention relates to a moisture-proof laminated film having, on the substrate thereof, an inorganic thin film layer and having, on the inorganic thin film layer, a plastic film via a polyurethane adhesive satisfying the following requirement (1):

$$(1) \quad -0.1 \leq E21 \leq +0.5$$

(In the above formula, E21 indicates (E2 - E1)/E2; E1 means the tensile storage elastic modulus of the adhesive at 150°C, at a frequency of 10 Hz and at a strain of 0.1%; E2 means the tensile storage elastic modulus of the adhesive at 150°C, at a frequency of 10 Hz and at a strain of 0.1% after heat treatment at 150°C for 30 minutes.)

The second embodiment of the present invention relates to a moisture-proof laminated film having, on the substrate thereof, an inorganic thin film layer and having, on the inorganic thin film layer, a plastic film via a polyurethane adhesive satisfying the following requirements (1) and (2):

$$(1) \quad -0.1 \leq E21 \leq +0.5$$

$$(2) \quad -0.3 \leq E23 \leq +0.3$$

(In the above formulae, E21 indicates (E2 - E1)/E2; E23 indicates (E2 - E3)/E2; E1 represents the tensile storage elastic modulus of the adhesive at 150°C, at a frequency of 10 Hz and at a strain of 0.1%; E2 represents the tensile storage elastic modulus of the adhesive at 150°C, at a frequency of 10 Hz and at a strain of 0.1% after heat treatment at 150°C for 30 minutes; E3 represents the tensile storage elastic modulus of the adhesive at 150°C, at a frequency of 10 Hz and at a strain of 0.1% after heat treatment at 150°C for 30 minutes followed by a pressure cooker test (condition: 120°C, 32 hours) in accordance with JIS C 60068-2-66).

Preferably, the present invention is any of the following embodiments. 1. The moisture-proof laminated film according to the above-mentioned first embodiment, wherein the moisture-proofness degradation level represented by (b - a)/a x 100 (%), where (a) indicates the initial water vapor transmission rate of the film and (b) indicates the water vapor transmission rate of the film after heat treatment at 150°C for 30 minutes, is at most 100%.

2. The moisture-proof laminated film according to the above-mentioned first embodiment, wherein the interlayer strength of the film after heat treatment at 150°C for 30 minutes is at least 7.5 N/15 mm.

3. The moisture-proof laminated film according to the above-mentioned second embodiment, wherein the moisture-proofness degradation level represented by (c)/(a), where (a) indicates the initial water vapor transmission rate of the film and (c) indicates the water vapor transmission rate of the film after heat treatment at 150°C for 30 minutes followed by a pressure cooker test, is at most 15 times.

4. The moisture-proof laminated film according to the above-mentioned second embodiment, wherein the interlayer strength of the film after heat treatment at 150°C for 30 minutes followed by a pressure cooker test is at least 7.0 N/15 mm.

5. The moisture-proof laminated film according to the above-mentioned first or second embodiment, wherein the main ingredient of the polyurethane adhesive contains at least one selected from polycarbonate polyols, polyether polyols and polyurethane polyols in an amount of from 20 to 70% by mass.

6. The moisture-proof laminated film according to the above-mentioned first or second embodiment, wherein the initial moisture-proofness in terms of the water vapor transmission rate of the film is less than 0.1 g/m$^2$·day.

7. The moisture-proof laminated film according to the above-mentioned first or second embodiment, wherein the initial moisture-proofness in terms of the water vapor transmission rate of the film is at most 0.05 g/m$^2$·day.

8. The moisture-proof laminated film according to the above-mentioned first or second embodiment, wherein the plastic film is at least one selected from polyester films, acrylic films and polycarbonate films.

9. The moisture-proof laminated film according to the above-mentioned first or second embodiment, wherein the plastic film is a film formed of a mixture of a polyester resin and an UV absorbent.

10. The moisture-proof laminated film according to the above-mentioned first or second embodiment, wherein the plastic film is a fluororesin film.

11. The moisture-proof laminated film according to the above-mentioned first or second embodiment, wherein the substrate is a polyester film.

12. The moisture-proof laminated film according to the above-mentioned first or second embodiment, wherein the film is used in solar cell surface protective members.

13. A solar cell module having the moisture-proof laminated film of the above-mentioned first or second embodiment.

Advantageous Effects of Invention

According to the first embodiment of the present invention, there is provided a moisture-proof laminated film which is excellent in moisture-proofness and interlayer strength and of which the moisture-proofness and the interlayer strength do not degrade even after exposed to high-temperature conditions.
According to the second embodiment of the present invention, there is provided a moisture-proof laminated film which is excellent in moisture-proofness and interlayer strength and of which the moisture-proofness and the interlayer strength do not degrade even after processed for vacuum lamination and subsequent accelerated tests.
According to the first embodiment or the second embodiment of the present invention as above, there is provided a moisture-proof laminated film which is effective for preventing the performance degradation of electronic devices such as solar cells and others and is effective for weight saving, durability enhancement and design performance enhancement of those devices.

Description of Embodiments

The moisture-proof laminated film of the present invention is a film excellent in moisture-proofness and usable for protection of the inner surface side from moisture penetration thereinto, and has, on the substrate thereof, an inorganic thin film layer and has, on the inorganic thin film layer, a plastic film via a polyurethane adhesive satisfying the above-mentioned requirement (1) or the above-mentioned requirements (1) and (2).

<Substrate>

Preferably, the substrate is a resin film, and as the material thereof, herein usable with any specific limitation is any resin usable for ordinary wrapping or packaging materials.
Concretely, the resin includes polyolefins of homopolymers or copolymers of ethylene, propylene, butene or the like; amorphous polyolefins such as cyclic polyolefins; polyesters such as polyethylene terephthalate (PET), polyethylene naphthalate (PEN), etc.; polyamides such as nylon 6, nylon 66, nylon 12, copolymer nylon, etc.; ethylene/vinyl acetate copolymer partial hydrolyzates (EVOH), polyimide, polyether imide, polysulfone, polyether sulfone, polyether ether ketone, polycarbonate, polyvinyl butyral, polyarylate, fluororesin, acrylate resin, biodegradable resin, etc.
Of those, preferred are thermoplastic resins; and more preferred are materials of polyolefin, polyester and polyamide from the viewpoint of the film properties and the cost thereof. Above all, from the viewpoint of the surface smoothness, the film strength, the heat resistance, etc.; especially preferred are materials of polyethylene terephthalate (PET) and polyethylene naphthalate (PEN).
The substrate film may contain any known additives, for example, antistatic agent, UV absorbent, plasticizer, lubricant, filler, colorant, stabilizer, release agent, crosslinking agent, antiblocking agent, antioxidant, etc.
The substrate film is a film formed of the above-mentioned material; and in case where the film is used as the substrate, it may be an unstretched or stretched one. Two or more different types of plastic films may be laminated to be the substrate.
The substrate may be produced according to any conventional known method. For example, a starting resin is melted in an extruder, then extruded through a ring die or a T-die, and rapidly cooled to produce a substantially amorphous unstretched film with no orientation. Using a multilayer die, a single-layer film formed of one type of resin, or a multilayer film formed of one type of resin, or a multilayer film formed of multiple types of resins may be produced.
The unstretched film may be stretched in the film flow direction (machine direction) or in the direction vertical to the film flow direction (lateral direction), according to a known method of monoaxial stretching, tenter-type successive biaxial stretching, tenter-type simultaneous biaxial stretching, tubular-type simultaneous biaxial stretching or the like, thereby producing a film stretched in at least one axial direction. The draw ratio in stretching may be preset in any desired manner, but is preferably so preset that the thermal shrinkage of the film at 150°C could be from 0.01 to 5%, more preferably from 0.01 to 2%. In particular, from the viewpoint of the film properties thereof, preferred is a biaxially-stretched polyethylene naphthalate film or a co-extruded biaxially-stretched film of polyethylene terephthalate and/or polyethylene naphthalate with any other resin.
The thickness of the substrate is generally from 5 to 100 $\mu$m, but is preferably from 8 to 50 $\mu$m, more preferably from 12 to 25 $\mu$m from the viewpoint of the productivity and the handleability of the film.
Preferably, an anchor-coating agent is applied to the substrate for enhancing the adhesiveness thereof to an inorganic thin film. As the anchor-coating agent, usable here are one or more of solvent-base or water-base polyester resins, isocyanate resins, urethane resins, acrylic resins, vinyl-modified resins, vinyl alcohol resins, vinyl butyral resins, ethylene vinyl alcohol resins, nitrocellulose resins, oxazoline group-containing  resins, carbodiimide group-containing resins, melamine group-containing resins, epoxy group-containing resins, modified styrene resins, modified silicone resins, etc. One alone or two or more different types of these resins may be used here either singly or as combined.
In addition, the film may further contain a silane-based coupling agent, a titanium-based coupling agent, a UV absorbent, a stabilizer, a release agent, a blocking inhibitor, an antioxidant, etc., and a copolymer prepared by copolymerizing any of these with the above-mentioned resin may also be used.
The thickness of the anchor-coating layer is preferably from 10 to 200 nm, more preferably from 10 to 100 nm from the viewpoint of enhancing the adhesiveness thereof to the inorganic thin film. For forming the anchor-coating layer, any known coating method is suitably employed here. For example, any coating method using a reverse roll coater, a gravure coater, a rod coater, an air-doctor coater or a spray is usable here. The substrate may be immersed in a resin liquid. After coated, the substrate may be dried according to any known drying method of hot air drying at a temperature of from 80 to 200°C or so, or drying under heat such as hot roll drying or the like, or IR drying, etc., to thereby vaporize the  solvent. In addition, for enhancing water resistance and durability thereof, the layer may be crosslinked through irradiation to electron beams. For forming the anchor-coating layer, employable here is an in-line method of forming the layer in the production line for the substrate film, or an off-line method of forming the layer after the substrate film production.

<Inorganic Thin Film Layer>

The material to constitute the inorganic thin film layer to be formed on the substrate includes silicon, aluminium, magnesium, zinc, tin, nickel, titanium, carbon hydride and the like, as well as oxides, carbides and nitrides thereof, and mixtures thereof. Of those, for example, in case where a transparent inorganic thin film is formed, preferred are silicon oxide, aluminium oxide, and diamond like carbon; and in case where the formed film is required to stably maintain high-level gas-barrier properties, preferred are silicon oxide, silicon nitride, silicon oxynitride and aluminium oxide.
As the method for forming the inorganic thin film layer, herein employable is any method of a vapor deposition method, a coating method or the like. Preferred is a vapor deposition method as capable of forming a uniform thin film with high-level gas-barrier performance. The vapor deposition method includes physical vapor deposition method (PVD), a chemical vapor deposition method (CVD), etc. The physical vapor deposition method includes vacuum evaporation, ion plating, sputtering, etc. The chemical vapor deposition includes plasma CVD using plasma, catalytic chemical vapor deposition (Cat-CVD) of catalytically thermal-cracking a material gas by the use of a thermal catalyst, etc. The inorganic thin film layer may be a single layer or may have a multilayer configuration formed of multiple layers.
The thickness of the inorganic thin film layer is preferably from 30 to 1,000 nm, more preferably from 40 to 800 nm, even more preferably from 50 to 600 nm from the viewpoint of the capability of expressing stable moisture-proofness.

<Polyurethane Adhesive>

The polyurethane adhesive to constitute the moisture-proof laminated film of the first embodiment of the present invention satisfies the following requirement (1):

$$(1) \quad -0.1 \leq E21 \leq +0.5$$

In the above formula, E21 indicates (E2 - E1)/E2; E1 means the tensile storage elastic modulus of the adhesive at 150°C, at a frequency of 10 Hz and at a strain of 0.1%; E2 means the tensile storage elastic modulus of the adhesive at 150°C, at a frequency of 10 Hz and at a strain of 0.1% after heat treatment at 150°C for 30 minutes.
The adhesive that satisfies the above-mentioned requirement (1) must be such that it can maintain the adhesion strength thereof in long-term outdoor use and does not cause delamination or the like owing to degradation thereof and does not yellow, and in addition, the adhesive must be so stable that, after cured, the adhesive layer undergoes little structure change under thermal lamination conditions or in accelerated tests.
The polyurethane adhesive to constitute the moisture-proof laminated film of the second embodiment of the present invention satisfies the following requirements (1) and (2):

$$(1) \quad -0.1 \leq E21 \leq +0.5$$

$$(2) \quad -0.3 \leq E23 \leq +0.3$$

In the above formula (1), E21 indicates (E2-E1)/E2; E1 represents the tensile storage elastic modulus of the adhesive at 150°C, at a frequency of 10 Hz and at a strain of 0.1%; E2 represents the tensile storage elastic modulus of the adhesive at 150°C, at a frequency of 10 Hz and at a strain of 0.1% after heat treatment at 150°C for 30 minutes.
In the above formula (2), E23 indicates (E2-E3)/E2; E3 represents the tensile storage elastic modulus of the adhesive at 150°C, at a frequency of 10 Hz and at a strain of 0.1% after heat treatment at 150°C for 30 minutes followed by a pressure cooker test (condition: 120°C, 32 hours).
Satisfying the above-mentioned requirement (1), the adhesive has little composition change in heating and, as a result, the stress to be loaded on the inorganic thin film layer in the vacuum lamination process and the residual strain in the adhesive interface of the laminate can be reduced and the moisture-proofness of the laminated film can be thereby prevented from lowering. From this viewpoint, E21 is from -0.1 to +0.5, preferably from 0 to +0.3, more preferably from 0 to +0.1.
In the present invention, the value of E1 is preferably from 0.4 to 4.0 MPa from the viewpoint of maintaining stable adhesion force and adhesive film, more preferably from 0.4 to 3.6 MPa, even more preferably from 0.8 to 3.0 MPa.

Satisfying the above-mentioned requirement (2), the adhesive undergoes little composition change after heat treatment in vacuum lamination and further even after exposed to high-temperature high-humidity environments and, as a result, the stress to be loaded on the inorganic thin film layer in the accelerated test can be reduced and the moisture-proofness of the laminated film can be thereby prevented from lowering. From this viewpoint, E23 is from -0.3 to +0.3, preferably from -0.2 to +0.2, more preferably from -0.1 to +0.1.

In the present invention, the value of E3 is preferably from 0.4 to 4.0 MPa from the viewpoint of maintaining stable adhesion force and adhesive film, more preferably from 0.4 to 3.6 MPa, even more preferably from 0.8 to 3.0 MPa.

The value of E3 changes depending on the accelerated test conditions to be employed, and accordingly, the most suitable range of E23 also changes depending on the accelerated test conditions. The above-mentioned range of E23 in the present invention is according to the pressure cooker test under accelerated conditions of 120°C and 100% humidity for 32 hours.

The above-mentioned values E1, E2 and E3 can be measured with a commercially-available viscoelastometer (for example, IT Keisoku's Viscoelastometer, trade name "Viscoelasticity Spectrometer DVA-200"), etc.

The adhesive that satisfies the above-mentioned requirement (1) and the adhesive that satisfies the above-mentioned requirements (1) and (2) can be prepared by suitably selecting the main ingredient and the curing agent as the composition of the adhesive to be mentioned below, and by suitably selecting the range of the blend ratio of the main ingredient and the curing agent to be mentioned below.

Regarding the adhesive composition that could not reach the saturated crosslinking degree under the curing condition in dry lamination, or the adhesive composition that may be additionally crosslinked at the vacuum lamination temperature, in case where the adhesive layer is additionally crosslinked in heating at 150°C for 30 minutes, then the tensile elastic modulus E2 after the heat treatment may be higher than that before the heat treatment, or that is, E21 is nearer to 1. For preventing this, it is necessary to control the amount of the uncrosslinked component in the adhesive between the films after the curing condition at a practicable temperature for a practicable period of time.

On the other hand, in case where the functional group necessary for crosslinking is insufficient, then the polymer network could not be formed sufficiently even after sufficient curing, and in this case, the adhesive layer causes the reduction in the elastic modulus E2 owing to the insufficiency in the cohesion force in heating and, as a result, E21 is to be a minus value. The increase/decrease of the above E21 that indicates the structure change inside the adhesive layer, as well as the change in the structure and the composition of the layer corresponds to the shrinkage and expansion of the adhesive layer itself.

For satisfying the above-mentioned requirement, it is desirable that the crosslinking goes on sufficiently through coating with the adhesive and through curing of the adhesive and that the amount of the remaining uncrosslinked functional groups is small. For this, as the main ingredient of the polyurethane adhesive, preferably used is a polyol having a molecular weight of from 400 to 20,000 in consideration of the balance between the coating film formability and the reactivity in curing, and more preferred is use of a polyol having a molecular weight of from 600 to 10,000. In order that the crosslinking reaction could fully go on in curing the adhesive, it is desirable that the hydroxyl group of the main ingredient, polyol and the isocyanate group of the curing agent could fully get near to each other. For this, it is desirable that the molecular weight of the curing agent to be used for the polyurethane adhesive is smaller. Concretely, the molecular weight of the diisocyanate or the polyisocyanate that may be contained in the curing agent is preferably from 100 to 10,000, more preferably from 1,000 to 5,000. On the contrary, it may also be possible to make the molecular weight of the polyol of the main ingredient smaller than the molecular weight of the curing agent, polyisocyanate.

On the basis of the idea that a main ingredient and a curing agent that differ in point of the molecular weight thereof are used for attaining a sufficient crosslinking density and for reducing the number of the remaining functional groups, for example, employable is a method of using different types of polyols each having a different molecular weight as the main ingredient.

Regarding the physical properties of the adhesive based on the above-mentioned planning, it is desirable that the ratio of (viscosity of the main ingredient/viscosity of curing agent) or (viscosity of curing agent/viscosity of main ingredient) is 5 or more, more preferably 10 or more. Also preferably, the viscosity of the main ingredient is from 100 to 1,500 (mPa·s, 25°C), more preferably from 400 to 1,300 (mPa·s, 25°C); and preferably, the viscosity of the curing agent is from 30 to 3,000 (mPa·s, 25°C).

Concretely, the main ingredient of the adhesive includes polycarbonate polyols, polyether polyols, polyacryl polyols, polyurethane polyols, polyester polyols, etc. In particular, from the viewpoint of enhancing the thermal stability and the hydrolysis resistance of the adhesive, preferred are polycarbonate polyols, polyether polyols and polyurethane polyols.

Also preferably, the main ingredient of the adhesive contains at least one selected from polycarbonate polyols, polyether polyols and polyurethane polyols in an amount of from 20 to 70% by mass, more preferably from 30 to 50% by mass. In case where two or more selected from polycarbonate polyols, polyether polyols and polyurethane polyols are used as combined, the above-mentioned content means the total amount of them. From the viewpoint of enhancing the hydrolysis resistance of the adhesive, preferably, the polyol to be contained in the main ingredient is at least one selected from polycarbonate polyols, polyether polyols and polyurethane polyols, and the amount thereof to be in the main ingredient is preferably at least 20% by mass, more preferably at least 30% by mass. From the viewpoint of preventing the molecular structure of the polyol from being rigid so that the adhesive can fully express the stress relaxation effect thereof, preferably, the polyol to be contained in the main ingredient is at least one selected from polycarbonate polyols, polyether polyols and polyurethane polyols, and the amount thereof to be in the main ingredient is preferably at most 70% by mass, more preferably at most 50% by mass.

Polycarbonate polyols can be produced, for example, starting from diphenyl carbonate and a diol such as ethylene glycol, propylene glycol, butanediol, neopentyl glycol (NPG), cyclohexanediol or the like.

Polyether polyols can be produced, for example, through ring-opening polymerization of an alkylene oxide such as ethylene oxide, propylene oxide, tetrahydrofuran or the like with an alkaline catalyst or an acid catalyst. As the active hydrogen-containing compound that is the starting material for the ring-opening polymerization, usable is a polyalcohol such as ethylene glycol, propylene glycol, 1,4-butanediol, 1,6-hexanediol or the like.

Polyacryl polyols can be produced through copolymerization of a hydroxyl group-having (meth)acrylate with any other monomer. The hydroxyl group-having (meth)acrylate includes, for example, hydroxyethyl acrylate, hydroxypropyl acrylate, hydroxybutyl acrylate, hydroxyethyl methacrylate, hydroxypropyl methacrylate, hydroxybutyl methacrylate, methyl methacrylate, butyl methacrylate, cyclohexyl methacrylate having an alicyclic structure, etc. Preferred are polyacryl polyols produced through polymerization of a monomer such as methyl methacrylate, butyl methacrylate, cyclohexyl methacrylate having an alicyclic structure, etc., or polyacryl polyols produced through copolymerization of such a monomer.

Polyurethane polyols may be produced through urethanation of a diol with a diisocyanate in a ratio of the hydroxyl group to the isocyanate group of at least 1. As the components of polyurethane polyols, a diol component and a diisocyanate component may be selected in a desired manner.

The diol component and the diisocyanate compound may be selected in consideration of the flowability of the polyurethane polyol and the solubility thereof in solvent, etc. As the diol component, preferred is a diol having primary hydroxyl groups such as propylene glycol, tetramethylene glycol, neopentyl glycol, etc. As the isocyanate component, there are mentioned aliphatic diisocyanates, alicyclic diisocyanates and aromatic diisocyanates.

Polyester polyols include, for example, those composed of a dicarboxylic acid compound such as succinic acid, glutaric acid, adipic acid, isophthalic acid (IPA), terephthalic acid (TPA), etc., and a diol such as ethylene glycol, propylene glycol, butanediol, neopentyl glycol, cyclohexanediol, etc., or polytetramethylene glycol, etc.

The adhesive containing a material of polyester polyol is preferred in that the adhesiveness thereof to substrate is high; however, from the viewpoint of preventing thermal degradation owing to hydrolysis of the ester bond therein, preferably selected is a polyester polyol in which the number of the ester bond groups to be hydrolysis points is small. For example, preferred are glycols having a long alkyl chain such as neopentyl glycol (NPG), etc.; and glycols having an alicyclic structure such as 1,4-cyclohexanedimethanol, etc.

Further, also preferred is selecting a hydrolysis-resistant polyester polyol that contains a polyether structure in the main chain structure thereof, such as polytetramethylene glycol (PTMG). Of the polyester polyol of the type, the molecular weight per one ester group therein is preferably from 100 to 5,000, more preferably from 120 to 3,000.

As the curing agent for use in the adhesive, preferred is a diisocyanate, and for example, there are mentioned aliphatic diisocyanates such as hexamethylene diisocyanate (HDI), etc.; aromatic diisocyanates such as xylylene diisocyanate (XDI), diphenylmethane diisocyanate (MDI), etc.; alicyclic diisocyanates such as isophorone diisocyanate (IPDI), dicyclohexylmethane diisocyanate (H12MDI), etc.

As the curing agent capable of providing high heat resistance after curing, for example, preferred are the aromatic diisocyanate, XDI, and the alicyclic diisocyanate, IPDI, etc. Further, for preventing the adhesive from yellowing, more preferred are the alicyclic diisocyanate, IPDI, etc.

In case where the main ingredient contains a polycarbonate polyol, the adhesive is excellent in that its heat resistance and moisture-proofness are high, and from the viewpoint of yellowing resistance, the adhesive of the type is preferably combined with an HDI-based curing agent.

For forming the adhesive layer that are more thermally stable, preferred is use of the adhesive that contains an epoxy compound as the main ingredient thereof.

In the present invention, the preferred blend ratio of the main ingredient and the curing agent in the adhesive is such that the ratio by mass of main ingredient/curing agent is from 5 to 25 and that the ratio by mol of the functional groups, NCO/OH is from 0.8 to 9, from the viewpoint of reducing the remaining reactive functional group in the adhesive.

Any other component may be added to the adhesive in the present invention, in addition to the above-mentioned main ingredient and the curing agent thereto. Preferably, the additional component is in an amount of from 0 to 30 parts by mass relative to 100 parts by mass of the main ingredient. As the additional component, preferred are acrylic polymers, epoxy polymers, olefinic polymers, etc., for enhancing an adhesiveness. Also preferred for use herein are styrene-butadiene rubber and the like excellent in cold resistance and hydrolysis resistance.

Preferably, a UV absorbent is added to the adhesive in the present invention. As the UV absorbent, various types of commercial products are usable here, including benzophenone-type, benzotriazole-type, triazine-type, salicylate-type UV absorbents, etc.

The benzophenone-type UV absorbents include, for example, 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, 2,2',4,4'-tetrahydroxybenzophenone, etc.

The benzotriazole-type UV absorbents include, for example, hydroxyphenyl-substituted benzotriazole compounds, for example, 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole, 2-(2-hydroxy-3,5-di-t-butylphenyl)benzotriazole, etc.

The triazine-type UV absorbents include, for example, 2-[4,6-bis(2,4-dimethylphenyl)-1,3,5-triazin-2-yl]-5-(octyloxy)phenol, 2-(4,6-diphenyl-1,3,5-triazin-2-yl)-5-(hexyloxy)phenol, etc.

The salicylate-type UV absorbents include, for example, phenyl salicylate, p-octylphenyl salicylate, etc.

One alone or two or more different types of the above-mentioned UV absorbents may be used here either singly or as combined.

The amount of the UV absorbent to be added is generally from 0.01 to 2.0% by mass or so in the adhesive, but preferably from 0.05 to 0.5% by mass.

Apart from the above-mentioned UV absorbents, also usable here are hindered amine-type light stabilizers as a weather-resistant stabilizer for imparting weather resistance to the adhesive. The hindered amine-type light stabilizer does not absorb UV rays as compared with UV absorbents, but when combined with a UV-absorbent, it exhibits a noticeable synergistic effect.

The hindered amine-type light stabilizer includes dimethyl succinate/1-(2-hydroxyethyl)-4-hydroxy-2,2,6,6-tetramethylpiperidine polycondensate, poly[{6-(1,1,3,3-tetramethylbutyl)amino-1,3,5-triazine-2,4-diyl}{(2,2,6,6-tetramethyl-4-piperidyl)imino}hexamethylene{{2,2,6,6-tetramethyl-4-piperidyl}imino}], N,N'-bis(3-aminopropyl)ethylenediamine-2,4-bis[N-butyl-N-(1,2,2,6,6-pentamethyl-4-piperidyl)amino]-6-chloro-1,3,5-triazine condensate, bis(2,2,6,6-tetramethyl-4-piperidyl) sebacate, bis(1,2,2,6,6-pentamethyl-4-piperidyl) 2-(3,5-di-tert-4-hydroxybenzyl)-2-n-butylmalonate, etc. One alone or two or more different types of these may be used here either singly or as combined.

The amount of the hindered amine-type light stabilizer to be added is, in general, from 0.01 to 0.5% by mass or so in the adhesive, but preferably from 0.05 to 0.3% by mass.

The above-mentioned adhesive may be applied, for example, according to a roll coating method, a gravure roll coating method, a kiss coating method or any other coating method, etc. The coating amount is preferably from 0.1 to 10 g/m$^2$ (in dry) or so. Preferably, the thickness of the adhesive layer is from 1 to 15 $\mu$m, more preferably from 3 to 10 $\mu$m.

As described above, the requirements (1) and (2) can be attained, for example, according to a method of suitably selecting the type of the polyol component for  use as the main ingredient of the adhesive and optimizing the molecular weight thereof; but of those, in the present invention, preferably employed is a method of selecting a polycarbonate polyol, a polyether polyol or the like and optimizing the molecular weight thereof from the viewpoint of the hydrolysis resistance of the adhesive.

<Plastic Film>

The plastic film for use in the moisture-proof laminated film of the present invention is preferably one having a low degree of shrinkage since the shrinkage thereof in temperature change in vacuum lamination is small and since the stress transmission thereof to the adhesive layer and to the inorganic thin film layer can be retarded. For example, usable here is a low-shrinkage weather-resistant substrate of polyethylene naphthalate or the like may be used; and in case where a polyethylene terephthalate film or a fluorine-containing film having a high degree of shrinkage is desired to be used here, the film may be previously heat-treated to lower the degree of shrinkage thereof.

Preferably, the plastic film is excellent in weather resistance, and for example, fluororesin films, polyester films, acrylic films and polycarbonate films are  preferred here, to which, however, the present invention is not limited.

As the fluororesin films, for example, there are mentioned polytetrafluoroethylene (PTFE), tetrafluoroethylene/perfluoroalkylene vinyl ether copolymer (PFA), tetrafluoroethylene/hexafluoropropylene copolymer (FEP), tetrafluoroethylene/ethylene copolymer (ETFE), polychlorotrifluoroethylene (PCTFE), polyvinylidene fluoride (PVDF), polyvinyl fluoride (PVF), etc.

Preferred here is use of a film formed of a mixture of an acrylic, polycarbonate, polyethylene terephthalate (PET), polyethylene naphthalate (PEN) or the like resin and a UV absorbent.

From the viewpoint of long-term durability, more preferred are tetrafluoroethylene/ethylene copolymer (ETFE), and tetrafluoroethylene/hexafluoropropylene copolymer (FEP).

From the viewpoint of long-term weather resistance and film shrinkage, preferred are a film formed of a mixture of a polyester resin such as polyethylene terephthalate (PET), polyethylene naphthalate (PEN) or the like and a UV absorbent, and a film formed by coating a polyester film of PET, PEN or the like with a UV absorbent.

The above-mentioned UV absorbent may be the same one as that in the above-mentioned adhesive. One alone or two or more different types of the above-mentioned resins may be used here either singly or as combined.

In consideration of the use of the film for solar cell protective materials, the film is preferably a weather-resistant film rich in flexibility and excellent in heat resistance, moisture-proofness and UV-resistant durability, and is more preferably a fluororesin film or a hydrolysis-resistant polyester film.

The thickness of the plastic film is generally from 20 to 200 $\mu$m or so, but is preferably from 20 to 100 $\mu$m, more preferably from 20 to 50 $\mu$m from the viewpoint of the handleability and the cost of the film.

If desired, various additives may be added to the moisture-proof laminated film. The additives include, for example, a silane coupling agent, an antioxidant, a weather-resistant stabilizer, a light diffusing agent, a nucleating agent, a pigment (e.g., white pigment), a flame retardant, a discoloration inhibitor, etc. In the present invention, preferred is adding at least one additive selected from a silane coupling agent, an antioxidant, a UV absorbent and a weather-resistant stabilizer for the reasons mentioned below. In the present invention, a crosslinking agent and/or a crosslinking promoter may be added to the film in case where the film is required to have high-level heat resistance.

As examples of the silane coupling agent, there are mentioned compounds having an unsaturated group such as a vinyl group, an acryloxy group or a methacryloxy group, as well as an amino group, an epoxy group or the like, and additionally having a hydrolysable group such as an alkoxy group. Specific examples of the silane coupling agent include N-($\beta$-aminoethyl)-$\gamma$-aminopropyltrimethoxysilane, N-($\beta$-aminoethyl)-$\gamma$-aminopropylmethyldimethoxysilane, $\gamma$-aminopropyltriethoxysilane, $\gamma$-glycidoxypropyltrimethoxysilane, $\gamma$-methacryloxypropyltrimethoxysilane, etc. One alone or two or more different types of these may be used here either singly or as combined. In the present invention, preferred is use of $\gamma$-glycidoxypropyltrimethoxysilane or $\gamma$-methacryloxypropyltrimethoxysilane as securing good adhesiveness and causing little discoloration such as yellowing.

The amount of the silane coupling agent to be added is generally from 0.1 to 5% by mass or so in each film to constitute the moisture-proof laminated film, but preferably from 0.2 to 3% by mass. Like the silane coupling agent, any other coupling agent of an organic titanate compound or the like may also be used effectively here.

Various commercial products are usable here as the antioxidant. There are mentioned various types of phenol-type antioxidants such as monophenol-type, bisphenol-type, polymeric phenol-type antioxidants, as well as phosphite-type antioxidants, etc.

The monophenol-type antioxidants include, for example, 2,6-di-tert-butyl-p-cresol, butylated hydroxyanisole, 2,6-di-tert-butyl-4-ethylphenol, etc. The bisphenol-type antioxidants include 2,2'-methylenebis(4-methyl-6-tert-butylphenol), 2,2'-methylenebis(4-ethyl-6-tert-butylphenol), 4,4'-thiobis(3-methyl-6-tertbutylphenol), 4,4'-butylidenebis(3-methyl-6-tert-butylphenol), 3,9-bis[{1,1-dimethyl-2-{$\beta$-(3-tert-butyl-4-hydroxy-5-methylphenyl)propionyloxy}ethyl}2,4,9,10-tetroxaspiro]-5,5-undecane, etc.

The polymeric phenol-type antioxidants include 1,1,3-tris(2-methyl-4-hydroxy-5-tert-butylphenyl)butane, 1,3,5-trimethyl-2,4,6-tris(3,5-di-tert-butyl-4-hydroxybenzyl)benzene, tetrakis-{methylene-3-(3',5'-di-tert-butyl-4'-hydroxyphenyl)propionate}methane, bis{(3,3'-bis-4'-hydroxy-3'-tert-butylphenyl)butyric acid} glucose ester, 1,3,5-tris(3',5'-di-tert-butyl-4'-hydroxybenzyl)-s-triazine-2,4,6-(1H,3H,5H)trione, triphenol(vitamin E), etc.

The phosphite-type antioxidants include triphenyl phosphite, diphenylisodecyl phosphite, phenyldiisodecyl phosphite, 4,4'-butylidene-bis(3-methyl-6-tert-butylphenyl-di-tridecyl) phosphite, cyclic neopentane-tetrayl bis(octadecyl phosphite), tris(mono and/or di)phenyl phosphite, diisodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phosphaphenanthrene, cyclic neopentane-tetrayl bis(2,4-di-tert-butylphenyl) phosphite, cyclic neopentane-tetrayl bis(2,6-di-tert-methylphenyl) phosphite, 2,2-methylenebis(4,6-tert-butylphenyl)octyl phosphite, etc.

One alone or two or more different types of the above-mentioned antioxidants may be used here either singly or as combined.

In the present invention, preferably used are phenol-type and phosphite-type antioxidants from the viewpoint of the effect, the thermal stability and the economic potential thereof, and more preferably the two different types of antioxidants are combined for use herein. The amount of the antioxidant to be added is generally from 0.1 to 1% by mass or so in each film to constitute the moisture-proof laminated film, but preferably from 0.2 to 0.5% by mass.

<Method of Film Formation>

In the present invention, any other film than the above-mentioned substrate, inorganic thin film, polyurethane adhesive and plastic film (hereinafter this may be referred to as "the other film") may be further provided in the laminated film.

As the film formation method for the films that constitute the plastic film and the other film for use in the present invention, there may be employed any known method, for example, an extrusion casting method, a calendering method or the like using a melt mixing apparatus equipped with a single-screw extruder, a multi-screw extruder, a Banbury mixer, a kneader or the like and using a T-die. Though not specifically defined, in the present invention, preferred is an extrusion casting method using a T-die, from the viewpoint of the handleability and the productivity. The molding temperature in the extrusion casting method using a T-die may be suitably controlled depending on the flow characteristics and the film formability of the resin composition used, but is, in general, preferably from 200 to 350°C or so, more preferably from 250 to 300°C. Various additives such as a silane coupling agent, an antioxidant, a UV absorbent, a weather-resistant stabilizer and the like may be previously dry-blended with resin and then fed into a hopper; or all the materials may be previously melt-mixed and pelletized, and then the pellets may be fed thereinto; or a master batch in which the additives alone are previously concentrated in resin may be prepared and fed into the production line.

The moisture-proof laminated film of the present invention may be produced by sticking the films prepared as above using the polyurethane adhesive that satisfies the above-mentioned requirement (1) or the above-mentioned requirements (1) and (2), for example, by drying the adhesive at a temperature of from 100 to 140°C and laminating the films in a mode of dry lamination at a temperature of from 0 to 80°C. From the viewpoint of making the adhesive have a satisfactorily saturated degree of crosslinking, it is desirable that the obtained laminate is cured at a temperature of from 30 to 80°C for a period of from 3 to 6 days. Thus obtained, the moisture-proof laminated film of the present invention is excellent in softness and moisture-proofness, of which the moisture-proofness and the interlayer strength do not lower even after the heat treatment under the thermal lamination condition.

The thickness of the moisture-proof laminated film is not specifically defined. In general, the film is used in the form of a sheet having a thickness of from 25 to 300 μm or so, preferably from 40 to 100 μm, more preferably from 40 to 80 μm.

In case where any other film is further laminated thereon, the moisture-proof laminated film may be used in the form of a sheet having a total thickness of preferably from 30 to 500 μm, more preferably from 40 to 350 μm, even more preferably from 40 to 300 μm.

(Moisture-proofness)

Of the thus-obtained, the moisture-proof laminated film of the present invention, the initial moisture-proofness that is the moisture-proofness of the film before heat treatment is preferably less than 0.1 g/m$^2$·day in terms of the water vapor transmission rate thereof, more preferably at most 0.05 g/m$^2$·day. The moisture-proof laminated film of the present invention can be used as a surface protective material or the like for electronic devices that are required to have excellent moisture-proofness, and consequently, using the moisture-proof laminated film excellent in initial moisture-proofness is preferred as capable of more noticeably expressing the advantageous effects of the present invention.

In the first embodiment of the present invention, preferably, the moisture-proofness degradation level of the moisture-proof laminated film, as represented by (b - a)/a x 100 (%) where (a) indicates the initial water vapor transmission rate of the film and (b) indicates the water vapor transmission rate thereof after heat treatment at 150°C for 30 minutes, is at most 100%, more preferably at most 50%.

In the second embodiment of the present invention, preferably, the moisture-proofness degradation level of the moisture-proof laminated film, as represented by (c)/(a) where (a) indicates the initial water vapor transmission rate of the film and (c) indicates the water vapor transmission rate thereof after heat treatment at 150°C for 30 minutes followed by a pressure cooker test, is at most 15 times, more preferably at most 10 times. The pressure cooker test is according to JIS C 60068-2-66 (condition: 120°C, 32 hours).

Having specifically noted the point that the inorganic thin film surface is not degraded at high temperatures, the present inventors have planned the adhesive to be used and have attained the moisture-proof laminated film of the present invention. The degradation of the inorganic thin film surface is considered as follows: In case where the inorganic thin film layer and the adhesive form a strong chemical bond therebetween, then great stress would be given to the inorganic deposition layer owing to the change in the viscoelasticity of the adhesive and to the decomposition or shrinkage of the adhesive coating film, whereby microcracks would be formed in the inorganic thin film layer. On the contrary, in case where the adhesiveness between the inorganic thin film layer and the adhesive is weak, then the stress owing to the change in the physical properties of the adhesive coating film could be relieved and therefore the reduction in the barrier properties thereof could be prevented. The factor for forming the chemical bond between the inorganic thin film and the adhesive is considered, for example, because the defects of the SiOx layer would react with the hydroxyl group and others in the adhesive.

For preventing the above, it may be good to decrease the number of the reactive functional groups in the adhesive, for which, for example, first mentioned is decreasing the number of the unreacted functional groups after application and curing of the adhesive. For this, it is desirable to suitably select the blend ratio of the main ingredient and the curing agent.

In case where the adhesive is thermally decomposed at high temperatures, it produces a carboxylic acid and a hydroxyl group, and it is considered that these functional groups may form a chemical bond with the inorganic thin film layer to thereby cause degradation of the inorganic thin film layer. Consequently, as the polyol to be contained in the main ingredient, a polycarbonate polyol, a polyether polyol, a polyacrylic polyol, a polyurethane polyol or the like that is excellent in heat resistance is preferred to a polyester polyol that readily hydrolyzes. Accordingly, in case where a polyester polyol is used as the polyol to be contained in the main ingredient, its preferred amount is at most 50% by mass, more preferably at most 40% by mass.

Satisfying the above-mentioned moisture-proofness in the manner as above can prevent the degradation of power-generating devices and can prevent the internal conductor wires and electrodes in the devices from getting rusted.

The initial moisture-proofness of the moisture-proof laminated film of the present invention means the moisture-proofness thereof before the constitutive elements thereof receive high-temperature thermal history such as vacuum lamination or the like, and means the level of the moisture-proofness thereof prior to the start of moisture-proofness degradation owing to heat. Accordingly, the phenomenon includes the change in moisture-proofness over time immediately after production and before heat treatment. For example, the initial moisture-proofness indicates the level of the moisture-proofness of the film in a state where it is not as yet exposed to heat treatment such as a severe environmental test under high temperature (before and after 100°C) and high pressure, e.g., thermal lamination at from 130 to 180°C for from 10 minutes to 40 minutes, etc. Further, regarding the adhesive curing condition, the moisture-proofness of the cured film means the value thereof after left at a room temperature for a predetermined period of a few days after lamination and then left cured at from 30 to 80°C for 3 to 6 days.

The moisture-proofness may be evaluated under various conditions as in JIS Z 0222 "Method of permeability test for moisture proof packing case" and JIS Z 0208 "Testing methods for determination of the water vapour transmission rate of moisture-proof packaging materials (dish method)".

(Interlayer Strength)

In case where the adhesion power of the polyurethane adhesive to the inorganic thin film layer in the present invention is low from the beginning in producing the moisture-proof laminated film or in case where the adhesion power thereof lowers during vacuum lamination, the stress propagation from the adhesive to the inorganic thin film layer could be relived and the degradation of the moisture-proofness of the film can be thereby prevented.

However, in case where the interlayer strength of the moisture-proof laminated film does not satisfy the above-mentioned specific range, there is a probability that the use of the film in solar cell modules and the like would cause delamination of the film, and consequently, the interlayer strength of the moisture-proof laminated film of the present invention is preferably at least 4.0 N/15 mm after heat treatment at 150°C for 30 minutes, more preferably at least 7.0 N/15 mm, even more preferably at least 7.3 N/15 mm, still more preferably at least 7.5 N/15 mm, most preferably at least 8 N/15 mm. In particular, even after heat treatment at a temperature of from 130 to 180°C, which is higher than that in the thermal lamination in producing solar cell modules, for 30 minutes, it is desirable that the interlayer strength of the film is still at least 4.0 N/15 mm, more preferably at least 7.0 N/15 mm, even more preferably at least 7.3 N/15 mm, still more preferably at least 7.5 N/15 mm.

Further, of the moisture-proof laminated film of the second embodiment of the present invention, the interlayer strength after heat treatment at 150°C for 30 minutes followed by a pressure cooker test is preferably at least 7.0 N/15 mm, more preferably at least 8.0 N/15 mm. The condition for the pressure cooker test is as described above.

For maintaining the interlayer strength after heat treatment, there may be employed various other methods than that as mentioned in the above where the condition for selecting the adhesive is specifically taken into consideration. For example, in a wet heat resistance test at 85°C and 85% RH or in a case of outdoor exposure, when the tensile storage elastic modulus at 150°C of the adhesive coating film is too low, then the interlayer strength could not be kept high. Consequently, it is considered that the above-mentioned value is secured by controlling the tensile elastic modulus at 150°C of the adhesive to be at least 0.4 MPa. In addition, when the mobility of molecules increases at high temperatures, then the cohesion force thereof lowers and the interlayer strength is thereby lowered. A case where the remaining carboxylic acid and hydroxyl group would interact with the inorganic deposition layer at high temperatures to form new bonds can be taken into consideration. In this case, the interlayer strength can be kept high or can increase. However, the bonds partially formed at high temperatures tend to receive stress by shrinkage and therefore would not tend to attain uniform adhesiveness. Consequently, for example, it may be considered to attain the above-mentioned value by using, as the polyol to be contained in the main ingredient, a polycarbonate polyol or a polyether polyol that provides good adhesiveness and is excellent in heat resistance, rather than using a polyester polyol that is excellent in adhesiveness but may readily hydrolyze.

The interlayer strength can be measured in a 180-degree peeling test in which a predetermined rectangular test piece, as cut out of the laminated film, is tested with a tensile tester, as described below.

< Moisture-proof Laminated Film for Solar Cells>

The moisture-proof laminated film of the present invention is preferably used for applications of solar cells that are required to have long-term durability, especially for surface protective members for solar cells, as capable of preventing the power-generating units from being degraded by moisture penetration thereinto and preventing the internal conductor wires and electrodes in the devices from getting rusted, therefore securing long-term power generation capabilities of the devices.

The constitution of the moisture-proof laminated film for solar cells of the present invention, in which, in particular, the above-mentioned specific plastic film is stuck to the inorganic thin film layer via the above-mentioned specific polyurethane adhesive, realizes a moisture-proof laminated film excellent softness and moisture-proofness without degrading the moisture-proofness and the interlayer strength of the film even after exposed to high temperature conditions, and at the same time, the constitution of the film is effective for preventing the performance of solar cells from degrading and is also effective for weight saving of solar cells and for enhancing the durability and the design performance thereof, therefore providing an effective moisture-proof laminated film for solar cells.

<Production Method for Solar Cell Module, Solar Cell>

The moisture-proof laminated film is, directly as it is or after stuck to a glass plate or the like, usable as a surface protective member for solar cells. Any known method is employable for producing the solar cell molecule and/or the solar cell of the present invention by the use of the moisture-proof laminated film of the present invention.

Using the moisture-proof laminated film of the present invention in the layer constitution of a surface protective member such as a front sheet, a back sheet or the like for a solar cell and fixing the solar cell element along with a encapsulant gives a solar cell module. Various types of such solar cell modules are mentioned. Preferably, in case where the moisture-proof laminated film of the present invention is used as a front protective material, there is mentioned a solar cell module having a encapsulant, a solar cell element and a lower protective material along with the front protective material. Concretely, there are mentioned a configuration of upper protective material (moisture-proof laminated film of the present invention)/encapsulant (encapsulant resin layer)/solar cell element/encapsulant (encapsulant resin layer)/ lower protective material; a configuration where a encapsulant and an upper protective material (moisture-proof laminated film of the present invention) are formed on the solar cell element formed on the inner periphery of a lower protective material; a configuration where a encapsulant and a lower protective material are formed on the solar cell element, for example, an amorphous solar cell element formed by sputtering or the like on a fluororesin-based transparent protective material, as formed on the inner periphery of an upper protective material (moisture-proof laminated film of the present invention), etc.

The solar cell element includes, for example, single-crystal silicon-type, polycrystalline silicon-type or amorphous silicon-type solar cells; gallium-arsenic, copper-indium-selenium, copper-indium-gallium-selenium, cadmium-tellurium or the like III-V Group or II-VI Group compound semiconductor-type solar cells; dye-sensitized solar cells, organic thin film solar cells, etc.

In case where a solar cell module is produced by the use of the surface protective material in the present invention, a different type of a moisture-proof film is suitably selected from a range that covers from a low moisture-proof film having a moisture permeability of less than 1.0 $g/m^2 \cdot day$ or so to a high moisture-proof film having a moisture permeability of less than 0.01 $g/m^2 \cdot day$ or so, depending on the type of the solar cell power-generating device mentioned above, and the moisture-proof film is laminated with a weather-resistant film or the like using an adhesive.

The members to constitute the solar cell module produced by the use of the moisture-proof laminated film of the present invention are not specifically defined. For example, as the encapsulant, there is mentioned an ethylene/vinyl acetate copolymer. The lower protective material may be a single-layer or multilayer sheet of metals or various types of thermoplastic resin films. For example, there are mentioned single-layer or multilayer protective materials of metals such as tin, aluminium, stainless or the like, inorganic materials such as glass or the like, or polyester resins, fluororesins, polyolefin resins, etc.; as well as films produced by depositing an inorganic substance on these, or their laminates, etc. The surfaces of the upper and/or lower protective materials may be subjected to any known surface treatment such as primer treatment, corona treatment or the like, for enhancing the adhesiveness thereof to encapsulants and other members.

An example of the solar cell module produced by the use of the moisture-proof laminated film of the present invention is described, which has the above-mentioned configuration of upper protective film (moisture-proof laminated film of the present invention)/encapsulant/solar cell element/encapsulant/lower protective material. In this, the moisture-proof laminated film of the present invention, the encapsulant resin layer, the solar cell element, the encapsulant resin layer and the back sheet are laminated in that order from the sunlight-receiving side of the module, and further, a junction box (terminal box for connecting a wiring for taking out the generated electric power from the solar cell element) is adhered to the lower surface of the back sheet. The solar cell elements are connected by a wiring for electrically leading the generated current to the outside. The wiring is led to the outside via the through-hole formed in the back sheet, and is connected to the junction box.

Not specifically defined, any known production method is employable as the method for producing the solar cell module in the present invention, which generally  comprises a step of laminating the a moisture-proof laminated film of the present invention, a encapsulant resin layer, a solar cell element, a encapsulant resin layer, and a lower protective layer in that order, and a step of thermally bonding them under pressure through vacuum suction. A batch-type production line, a roll-to-roll production line or the like is applicable to the production method.

The solar cell module produced by the use of the moisture-proof laminated film of the present invention is usable in various applications, depending on the type of the solar cells used and on the shape of the module but irrespective of indoor use or outdoor use thereof, for small-size solar cells such as typically mobile instruments and for large-size solar cells to be installed on roofs or rooftop decks.

The solar cell module and/or the solar cell of the present invention can be produced with ease by bonding under heat and pressure the protective sheet for solar cells, the encapsulant, the power-generating device, the encapsulant and the back protective sheet according to a known process using a vacuum laminator, at a temperature of preferably from 130 to 180°C, more preferably from 130  to 150°C for a degassing time of from 2 to 15 minutes, under a pressing pressure of from 0.05 to 0.1 MPa and for a pressing time of preferably from 8 to 45 minutes, more preferably from 10 to 40 minutes.

Examples

The first embodiment of the present invention is described more concretely with reference to the following Examples, however, the present invention is not limited at all by these Examples and Comparative Examples. The sheets mentioned in the specification were analyzed for their data and evaluations, as mentioned below. In the following Examples, the thermal lamination condition was at 150°C and for 30 minutes.

(Measurement of Physical Properties)

(1) Storage Elastic Modulus E1 of Adhesive Layer (elastic modulus before heat treatment)

The prepared adhesive coating liquid was applied onto a silicone-lubricated PET film and cured at 40°C for 5 days to form an adhesive layer thereon. Subsequently, the adhesive layer alone was taken out, and using IT Measurement's viscoelasticity meter, trade name "Viscoelasticity Spectrometer DVA-200", a sample of the  adhesive layer (length 4 mm, width 60 mm, thickness 200 $\mu$m) was analyzed in the lateral direction thereof within a range of from -100°C to 180°C, at a frequency of 10 Hz, at a strain of 0.1% and at a rate of temperature rise of 3°C/min and with a chuck-to-chuck distance of 25 mm; and from the found data, the tensile storage elastic modulus (E1) [MPa] at 150°C of the sample was obtained. In case where the shape of the sample changed during temperature rising so that the sample was difficult to analyze at 150°C, then E21 of the sample was referred to as 1.

(2) Storage Elastic Modulus E2 of Adhesive Layer (elastic modulus after heat treatment)

The adhesive layer prepared in the same manner as in the above (1) was kept under thermal lamination condition, and thereafter the tensile storage elastic modulus (E2) [MPa] at 150°C thereof was obtained in the same manner as above.

(3) Moisture-proofness

According to various conditions in JIS Z 0222 "Method of permeability test for moisture proof packing case" and JIS Z 0208 "Testing methods for determination of the water vapour transmission rate of moisture-proof packaging materials (dish method)", the  water vapor transmission rate of the film was evaluated as follows to thereby determine the moisture-proofness thereof.

Two sheets of the sample film having a moisture-permeable area of 10.0 cm $\times$ 10.0 cm square were prepared, and formed into a pouch by sealing up the four sides thereof while about 20 g of a moisture absorbent, anhydrous calcium chloride was kept put therein. The pouch was put in a constant-temperature constant-humidity chamber having a temperature of 40°C and a relative humidity of 90%, and at intervals of 72 hours or more, its mass was measured for about 200 days. From the slope of the regression line of the elapsed time and the pouch mass after 4 days, the water vapor transmission rate was computed.

The initial water vapor transmission rate is the water vapor transmission rate of each moisture-proof laminated film obtained in the process of dry lamination for sticking followed by curing under the condition mentioned below.

The water vapor transmission rate after thermal treatment under thermal lamination condition is the water vapor transmission rate after heat treatment under thermal lamination condition of each sample prepared by laminating glass, encapsulant and each laminated moisture-proof sample (D-1 to D-9, in which the moisture-proof film faced the encapsulant side).

The moisture-proofness retention after heat treatment under thermal lamination condition of the sample was evaluated as follows:

○ (good): [(water vapor transmission rate after heat treatment under thermal lamination condition-initial water vapor transmission rate)/initial water vapor transmission rate] $\times$ 100 ≤ 100 [%]

$\times$ (not good): [(water vapor transmission rate after heat treatment under thermal lamination condition-initial water vapor transmission rate)/initial water vapor transmission rate] $\times$ 100 > 100 [%]

(4) Interlayer Strength Measurement by 180-Degree Peeling

The laminated film that had been produced by sticking in dry lamination, curing and heat treatment under thermal lamination condition was cut into a rectangular test piece having a measurement width of 15 mm. Using a tensile tester Orientic's STA-1150, the piece was tested for the interlayer lamination strength (N/15 mm) thereof at 300 mm/min and in the pulling direction of 180 degrees.

The interlayer strength retention after heat treatment under thermal lamination condition of the sample was evaluated as follows:

○ (good): interlayer strength after thermal treatment under thermal lamination condition/(initial) interlayer strength after curing ≥ 0.5

$\times$ (not good): interlayer strength after thermal treatment under thermal lamination condition/(initial) interlayer strength after curing < 0.5

(Constituent Films)

* Inorganic Thin Film Layer Film A

As the substrate film, used was a biaxially-stretched polyethylene naphthalate film (Teijin DuPont's trade name, Q51C12) having a thickness of 12 $\mu$m. A coating liquid mentioned below was applied onto the corona-treated surface of the film and dried to form a coat layer having a thickness of 0.1 $\mu$m.

Next, using a vacuum deposition apparatus, SiO was heated and evaporated in vacuum of 1.33 $\times$ 10$^{-3}$ Pa (1 $\times$ 10$^{-5}$ Torr), and formed an SiOx (x = 1.5) thin film having a thickness of 50 nm on the coat layer, thereby producing an inorganic thin film layer film A. The moisture-proofness of the thus-produced inorganic thin film layer film A was 0.01 g/m$^2$·day.

<Coating Liquid>

220 g of a polyvinyl alcohol resin, Nippon Gohsei's trade name Gohsenol (degree of saponification: 97.0 to 98.8 mol%, degree of polymerization: 2400) was added to 2810 g of ion-exchanged water and dissolved therein under heat to prepare an aqueous solution, and with stirring at 20°C, 645 g of 35 mass% hydrochloric acid was added thereto. Next, at 10°C, 3.6 g of butylaldehyde was added thereto with stirring, and after 5 minutes, 143 g of acetaldehyde was dropwise added thereto with stirring to thereby precipitate resin fine particles therein. Next, the liquid was kept at 60°C for 2 hours, cooled and neutralized with sodium hydrogencarbonate, then washed with water and dried to give a polyvinyl acetacetal resin powder (degree of acetalization, 75 mol%).

An isocyanate resin (Sumika Bayer Urethane's Sumidur N-3200) was used as crosslinking agent, and mixed with the above in an equivalent ratio of the isocyanate group to the hydroxyl group of 1/2.

* Adhesive and Adhesive Coating Liquid

<Adhesive Coating Liquid B-1>

A polyester polyol having a mean molecular weight of 1,000 (DIC's trade name, OD-X-210) and a polycarbonate diol having a mean molecular weight of 1,000 (Daicel Chemical's trade name, Placcel CD CD210) were mixed in a ratio by mass of 60/40 to prepare a main ingredient containing a polycarbonate polyol component, and this was dissolved in ethyl acetate to give a polyol solution having a solid content of about 50% by mass and a viscosity of 400 [mPa·s]. (In Table 1, this is represented by MPI0001.) A curing agent Sumidur N3300 (trade name by Sumika Bayer Urethane) was mixed in the solution to have a ratio (NCO/OH) = 2.5, and diluted with ethyl acetate to have a solid concentration of 35% by mass, thereby preparing an adhesive coating liquid B-1.

<Adhesive Coating Liquid B-2>

With reference to "Polyurethane Resin Synthesis Example 2" and "Examples" in JP-A 10-130615, the coating liquid was prepared as follows.

700 parts by mass of a polytetramethylene ether glycol having a number-average molecular weight of 1,000 (ADEKA's trade name, Adeka Polyether P-1000), 300 parts by mass of a polytetramethylene ether glycol having a number-average molecular weight of 2,000 (ADEKA's trade name, Adeka Polyether P-2000), 21.3 parts by mass of dipropylene glycol and 150 parts by mass of tolylene diisocyanate were put into a reactor and reacted at 80°C for 6 hours to give a polyether polyol that had been chain-extended with urethane bonding.

The polyol was dissolved in ethyl acetate to give a polyol solution having a viscosity of 900 [mPa·sec] and a solid content of about 50% by mass. (In Table 1, this is represented by MPI0002.) A curing agent IPDI (trade name by Sumika Bayer Urethane, Desmodur Z-4370) was dissolved in ethyl acetate to prepare a 70 mass% solution thereof. The polyol solution and the curing agent solution were mixed in a ratio of (NCO/OH) = 2.5, and diluted with ethyl acetate to have a solid concentration of 30% by mass, thereby preparing an adhesive coating liquid B-2.

<Adhesive Coating Liquid B-3>

A polycaprolactone polyol having a mean molecular weight of 2,000 (Daicel Chemical's trade name, Placcel 210N) and a polycarbonate diol having a mean molecular weight of 500 (Daicel Chemical's trade name, Placcel CD 205) were mixed in a ratio by mass of 60/40 to prepare a main ingredient containing a polyurethane polyol component, and this was dissolved in ethyl acetate to give a polyol solution having a solid content of about 50% by mass and a viscosity of 400 [mPa·s]. (In Table 1, this is represented by MPI0003.) A curing agent Sumidur N3300 (trade name by Sumika Bayer Urethane) was mixed in the solution to have a ratio (NCO/OH) = 2.5, and diluted with ethyl acetate to have a solid concentration of 35% by mass, thereby preparing an adhesive coating liquid B-3.

<Adhesive Coating Liquid B-4>

Toyo Ink Manufacturing's IS801 (trade name, having a molecular weight per one ester group of 105, and a viscosity of 1700 [mPa·sec]) was used as the main ingredient containing a polyester polyol component, and Toyo Ink Manufacturing's CR001 was used as the curing agent containing an aliphatic hexamethylene diisocyanate component and an alicyclic isophorone diisocyanate component; and these were mixed in a ratio by mass of 10/1, and diluted with ethyl acetate to have a solid concentration of 30 % by mass, thereby preparing an adhesive coating liquid B-4.

<Adhesive Coating Liquid B-5>

Mitsui Chemical Polyurethane's A1143 (trade name, having a molecular weight per one ester group of 109, and a viscosity of 500 [mPa·sec]) was used as the main ingredient containing a polyester polyol component, and Takenate A-50 (trade name by Mitsui Chemical) was used as the curing agent containing an alicyclic isophorone diisocyanate and an aromatic xylylene diisocyanate; and these were mixed in a ratio by mass of 9/1, and diluted with ethyl acetate to have a solid concentration of 35 % by mass, thereby preparing an adhesive coating liquid B-5.

The compositions of the above-mentioned adhesive coating liquids are shown together in Table 1.

[Table 1]

Table 1

| Adhesive Coating Liquid | Coating Liquid | | |
|---|---|---|---|
| | Main Ingredient | Curing Agent | Type of Polyol |
| B-1 | MPI0001 | N3300 | polycarbonate polyol |
| B-2 | MPI0002 | Z4370 | polyether polyol |
| B-3 | MPI0003 | N3300 | polyurethane polyol |
| B-4 | IS801 | CR001 | polyester polyol |
| B-5 | A1143 | A-50 | polyester polyol |

* Plastic Film

C-1: As a hydrolysis-resistant polyester film, used was Mitsubishi Plastics' hydrolysis-resistant polyethylene terephthalate film, trade name P100 (thickness: 50 $\mu$m).
C-2: As a fluororesin film, used was ARKEMA's polyvinylidene fluoride (PVDF) film, trade name Kynar 302-PGM-TR (thickness; 30 $\mu$m).

Example 1

The adhesive coating liquid B-1 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-1 having a thickness of 68 $\mu$m. The interlayer strength and the moisture-proofness of the film were measured before and after heat treatment under thermal lamination condition. The results are shown in Table 2.

Example 2

The adhesive coating liquid B-2 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-2 having a thickness of 68 $\mu$m. The interlayer strength and the moisture-proofness of the film were measured before and after heat treatment under thermal lamination condition. The results are shown in Table 2.

Example 3

The adhesive coating liquid B-3 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-3 having a thickness of 68 $\mu$m. The interlayer strength and the moisture-proofness of the film were measured before and after heat treatment under thermal lamination condition. The results are shown in Table 2.

Example 4

The adhesive coating liquid B-1 was applied to the plastic film (C-2) so that the solid content of the coating film could be 6 g/m$^2$, and dried, and the inorganic thin film layer film A was stuck thereto in dry lamination, and then cured at 40°C for 5 days to produce a moisture-proof laminated film D-4 having a thickness of 48 $\mu$m. The interlayer strength and the moisture-proofness of the film were measured before and after heat treatment under thermal lamination condition. The results are shown in Table 2.

Example 5

The adhesive coating liquid B-2 was applied to the plastic film (C-2) so that the solid content of the coating film could be 6 g/m$^2$, and dried, and the moisture-proof film A was stuck thereto in dry lamination, and then cured at 40°C for 5 days to produce a moisture-proof laminated film D-5 having a thickness of 48 $\mu$m. The interlayer strength and the moisture-proofness of the film were measured before and after heat treatment under thermal lamination condition. The results are shown in Table 2.

Comparative Example 1

The adhesive coating liquid B-4 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-6 having a thickness of 68 $\mu$m. The interlayer strength and the moisture-proofness of the film were measured before and after heat treatment under thermal lamination condition. The results are shown in Table 2.

Comparative Example 2

The adhesive coating liquid B-5 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-7 having a thickness of 68 μm. The interlayer strength and the moisture-proofness of the film were measured before and after heat treatment under thermal lamination condition. The results are shown in Table 2.

Comparative Example 3

The adhesive coating liquid B-4 was applied to the plastic film (C-2) so that the solid content of the coating film could be 6 g/m$^2$, and dried, and the moisture-proof film A was stuck thereto in dry lamination, and then cured at 40°C for 5 days to produce a moisture-proof laminated film D-8 having a thickness of 48 μm. The interlayer strength and the moisture-proofness of the film were measured before and after heat treatment under thermal lamination condition. The results are shown in Table 2.

Comparative Example 4

The adhesive coating liquid B-5 was applied to the plastic film (C-2) so that the solid content of the coating film could be 6 g/m$^2$, and dried, and the moisture-proof film A was stuck thereto in dry lamination, and then cured at 40°C for 5 days to produce a moisture-proof laminated film D-9 having a thickness of 48 μm. The interlayer strength and the moisture-proofness of the film were measured before and after heat treatment under thermal lamination condition. The results are shown in Table 2.

[Table 2]

Table 2

| | Moisture-proof Laminated Film | Adhesive Coating Liquid | | | | Plastic Film | Interlayer Strength | | | Moisture-proofness | | |
|---|---|---|---|---|---|---|---|---|---|---|---|---|
| | | type | E1 (MPa) | E2 (MPa) | E21=(E2-E1)/E2 | | Initial [N/15 mm] | After Heat Treatment [N/15 mm] | Retention | Initial [g/m²·day] | Initial [g/m²·day] | Retention |
| Example 1 | D-1 | B-1 | 3.53 | 3.20 | 0.10 | C-1 | 6.4 | 9.7 | ○ | 0.01 | 0.01 | ○ |
| Example 2 | D-2 | B-2 | 0.41 | 0.53 | 0.23 | C-1 | 6.8 | 7.4 | ○ | 0.01 | 0.01 | ○ |
| Example 3 | D-3 | B-3 | 2.1 | 2.05 | 0.02 | C-1 | 5.0 | 7.9 | ○ | 0.03 | 0.03 | ○ |
| Example 4 | D-4 | B-1 | 3.53 | 3.20 | 0.20 | C-2 | 6.0 | 9.1 | ○ | 0.01 | 0.01 | ○ |
| Example 5 | D-5 | B-2 | 0.41 | 0.53 | 0.23 | C-2 | 6.0 | 7.0 | ○ | 0.01 | 0.01 | ○ |
| Comparative Example 1 | D-6 | B-4 | - | 1.09 | 1.00 | C-1 | 7.8 | 3.0 | × | 0.01 | 0.01 | ○ |
| Comparative Example 2 | D-7 | B-5 | 0.14 | 0.69 | 0.80 | C-1 | 5.0 | >15 | ○ | 0.01 | 0.04 | × |
| Comparative Example 3 | D-8 | B-4 | - | 1.09 | 1.00 | C-2 | 7.5 | 2.6 | × | 0.01 | 0.01 | ○ |
| Comparative Example 4 | D-9 | B-5 | 0.14 | 0.69 | 0.80 | C-2 | 5.1 | >15 | ○ | 0.01 | 0.03 | × |

As shown in Table 2, it is obvious that, in Examples 1 to 5 in which the change of the storage elastic modulus before and after heat treatment at 150°C for 30 minutes of the polyurethane adhesive used was small (satisfying -0.1 ≤ E21 ≤ +0.5), both the interlayer strength and the moisture-proofness of the films were secured even after heat treatment under thermal lamination condition.

On the other hand, in Comparative Examples, the change of the storage elastic modulus before and after heat treatment at 150°C for 30 minutes of the polyurethane adhesive used was large (not satisfying -0.1 ≤ E21 ≤ +0.5), and it is obvious that, in Comparative Examples 1 and 3, the interlayer strength of the films greatly lowered, and in Comparative Examples 2 and 4, the moisture-proofness of the films was poor though the interlayer strength thereof was kept high.

The second embodiment of the present invention is described concretely hereinunder.

Also in these Examples, the thermal lamination condition was at 150°C and for 30 minutes, and the accelerated test, pressure cooker test was at 120°C and at a humidity of 100% for 32 hours.

In measurement and evaluation of the physical properties in Examples and Comparative examples, the storage elastic modulus E1 of the adhesive layer (elastic modulus before heat treatment), the storage elastic modulus E2 of the adhesive layer (elastic modulus after heat treatment), and the initial water vapor transmission rate were in the same manner as above, and the others were evaluated as follows.

(Measurement of Physical Properties)

(5) Storage Elastic Modulus E3 of Adhesive Layer (elastic modulus after pressure cooker test)

The adhesive layer prepared in the same manner as that in evaluation of the storage elastic modulus E2 of the adhesive layer (elastic modulus after heat treatment) as above was kept under thermal lamination condition, and then kept under pressure cooker condition, and thereafter tested for the tensile storage elastic modulus (E3) thereof (MPa) at 150°C like that for the above-mentioned E1.

(6) Water Vapor Transmission Rate after Pressure Cooker Test

The water vapor transmission rate of the moisture-proof laminated film after pressure cooker test is the water vapor transmission rate after heat treatment under thermal lamination condition followed by pressure cooker test of each sample prepared by laminating glass, encapsulant and each laminated moisture-proof sample (in which the moisture-proof film faced the encapsulant side).

According to various conditions in JIS Z 0222 "Method of permeability test for moisture proof packing case" and JIS Z 0208 "Testing methods for determination of the water vapour transmission rate of moisture-proof packaging materials (dish method)", the water vapor transmission rate of the film was evaluated as follows.

Two sheets of the each moisture-proof laminated film (D-1 to D-12) having a moisture-permeable area of 10.0 cm × 10.0 cm square were prepared, and formed into a pouch by sealing up the four sides thereof while about 20 g of a moisture absorbent, anhydrous calcium chloride was kept put therein. The pouch was put in a constant-temperature constant-humidity chamber having a temperature of 40°C and a relative humidity of 90%, and at intervals of 48 hours or more, its weight was measured (0.1 mg unit) for 14 days as an indication of the term after which the weight increase could be nearly constant, and the water vapor transmission rate of the film was computed according to the following formula.

$$\texttt{Water Vapor Transmission Rate (g/m}^2\texttt{·day) = (m/s)/t,}$$

m: mass increase (g) between the last two measuring times in the test period,
s: moisture-permeable area $(g/m^2)$,
t: time (h)/24(h) between the last two measuring times in the test period.
\* The degree of degradation of the moisture-proofness of the film after pressure cooker test, in terms of the water vapor transmission rate thereof, was computed as (water vapor transmission rate after pressure cooker test)/(initial water vapor transmission rate).

(7) Interlayer Strength after Pressure Cooker Test

Like in (6), each laminated moisture-prof film, which had been prepared by sticking in dry lamination and which had been heat-treated under thermal lamination condition and tested in the subsequent pressure cooker test, was cut into a rectangular sample having a measurement width of 15 mm. Using a tensile tester Orientic's STA-1150, the sample was tested for the interlayer lamination strength (N/15 mm) thereof at 300 mm/min and in the pulling direction of 180 degrees.

(Constituent Films)

The inorganic thin film layer film A, and the plastic films C-1 and C-2 used hereinunder are the same as those mentioned in the above.

<Adhesive Coating Liquid B-6>

A polycaprolactone polyol having a mean molecular weight of 2,000 (Daicel Chemical's trade name, Placcel 210N) and a polycarbonate diol having a mean molecular weight of 500 (Daicel Chemical's trade name, Placcel CD 205) were mixed in a ratio by mass of 60/40 to prepare a main ingredient containing a polyurethane polyol component, and this was dissolved in ethyl acetate to give a polyol solution having a solid content of about 50% by mass and a viscosity of 400 [mPa·s]. A curing agent Sumidur N3300 (trade name by Sumika Bayer Urethane) was mixed in the solution to have a ratio (NCO/OH) = 2.5, and diluted with ethyl acetate to have a solid concentration of 35% by mass, thereby preparing an adhesive coating liquid B-6.

<Adhesive Coating Liquid B-7>

A polycaprolactone polyol having a mean molecular weight of 2,000 (Daicel Chemical's trade name, Placcel 210N) and a polycarbonate diol having a mean molecular weight of 500 (Daicel Chemical's trade name, Placcel CD 205) were mixed in a ratio by mass of 60/40 to prepare a main ingredient containing a polyurethane polyol component, and this was dissolved in ethyl acetate to give a polyol solution having a solid content of about 50% by mass and a viscosity of 400 [mPa·s]. A curing agent Sumidur N3300 (trade name by Sumika Bayer Urethane) was mixed in the solution to have a ratio (NCO/OH) = 1.3, and diluted with ethyl acetate to have a solid concentration of 35% by mass, thereby preparing an adhesive coating liquid B-7.

<Adhesive Coating Liquid B-8>

With reference to "Polyurethane Resin Synthesis Example 2" and "Examples" in JP-A 10-130615, the coating liquid was prepared as follows.
700 parts by mass of a polytetramethylene ether glycol having a number-average molecular weight of 1,000 (ADEKA's trade name, Adeka Polyether P-1000), 300 parts by mass of a polytetramethylene ether glycol having a number-average molecular weight of 2,000 (ADEKA's trade name, Adeka Polyether P-2000), 21.3 parts by mass of dipropylene glycol and 150 parts by mass of tolylene diisocyanate were put into a reactor and reacted at 80°C for 6 hours to give a polyether polyol that had been chain-extended with urethane bonding.
The polyol was dissolved in ethyl acetate to give a polyol solution having a viscosity of 900 [mPa·s] and a solid content of about 50% by mass. A curing agent IPDI (trade name by Sumika Bayer Urethane, Desmodur Z-4370) was dissolved in ethyl acetate to prepare a 70 mass% solution thereof. The polyol solution and the curing agent solution were mixed in a ratio of (NCO/OH) = 2.5, and diluted with ethyl acetate to have a solid concentration of 30% by mass, thereby preparing an adhesive coating liquid B-8.

<Adhesive Coating Liquid B-9>

A polycaprolactone polyol having a mean molecular weight of 1,000 (Daicel Chemical's trade name, Placcel 210N) and a polycarbonate diol having a mean molecular weight of 1,000 (Daicel Chemical's trade name, Placcel CD 205) were mixed in a ratio by mass of 60/40 to prepare a main ingredient containing a polyurethane polyol component, and this was dissolved in ethyl acetate to give a polyol solution having a solid content of about 50% by mass and a viscosity of 500 [mPa·s]. A curing agent Sumidur N3300 (trade name by Sumika Bayer Urethane) was mixed in the solution to have a ratio (NCO/OH) = 2.5, and diluted with ethyl acetate to have a solid concentration of 35% by mass, thereby preparing an adhesive coating liquid B-9.

<Adhesive Coating Liquid B-10>

A polyester polyol having a mean molecular weight of 1,000 (DIC's trade name, OD-X-210) and a polycarbonate diol having a mean molecular weight of 1,000 (Daicel Chemical's trade name, Placcel CD CD210) were mixed in a ratio by mass of 60/40 to prepare a main ingredient containing a polycarbonate polyol component, and this was dissolved in ethyl acetate to give a polyol solution having a solid content of about 50% by mass and a viscosity of 400 [mPa·s]. A curing agent Sumidur N3300 (trade name by Sumika Bayer Urethane) was mixed in the solution to have a ratio (NCO/OH) = 2.5, and diluted with ethyl acetate to have a solid concentration of 35% by mass, thereby preparing an adhesive coating liquid B-10.

<Adhesive Coating Liquid B-11>

"TSB-700" (DIC's trade name, having a viscosity of 300 [mPa·s]) was used as the main ingredient containing a polyester polyol component; and "TSH-900" (DIC's trade name) was used as the curing agent containing a hexamethylene diisocyanate component, and these were mixed in a ratio by mass of 12/1. This was diluted with ethyl acetate to have a solid concentration of 35% by mass, thereby preparing an adhesive coating liquid B-11.

<Adhesive Coating Liquid B-12>

Toyo Ink Manufacturing's IS801 (trade name, having a molecular weight per one ester group of 105, and a viscosity of 1700 [mPa·s]) was used as the main ingredient containing a polyester polyol component, and Toyo Ink Manufacturing's CR001 was used as the curing agent containing an aliphatic hexamethylene diisocyanate component and an alicyclic isophorone diisocyanate component; and these were mixed in a ratio by mass of 10/1, and diluted with ethyl acetate to have a solid concentration of 30 % by mass, thereby preparing an adhesive coating liquid B-12.

<Adhesive Coating Liquid B-13>

Mitsui Chemical Polyurethane's A1143 (trade name, having a molecular weight per one ester group of 109, and a viscosity of 500 [mPa·s]) was used as the main ingredient containing a polyester polyol component, and Takenate A-50 (trade name by Mitsui Chemical) was used as the curing agent containing an alicyclic isophorone diisocyanate and an aromatic xylylene diisocyanate; and these were mixed in a ratio by mass of 9/1, and diluted with ethyl acetate to have a solid concentration of 35 % by mass, thereby preparing an adhesive coating liquid B-13.

Example 6

The adhesive coating liquid B-6 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-11 having a thickness of 68 $\mu$m. Glass, encapsulant and the moisture-proof laminated film D-11 were stacked in that order and laminated in vacuum at 150°C for 10 minutes, and then tested in a pressure cooker test. The interlayer strength and the moisture-proofness of the film were measured, and the results are shown in Table 3.

Example 7

The adhesive coating liquid B-7 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-12 having a thickness of 68 $\mu$m. Glass, encapsulant and the moisture-proof laminated film D-12 were stacked in that order and laminated in vacuum at 150°C for 10 minutes, and then tested in a pressure cooker test. The interlayer strength and the moisture-proofness of the film were measured, and the results are shown in Table 3.

Example 8

The adhesive coating liquid B-8 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-13 having a thickness of 68 $\mu$m. Glass, encapsulant and the moisture-proof laminated film D-13 were stacked in that order and laminated in vacuum at 150°C for 10 minutes, and then tested in a pressure cooker test. The interlayer strength and the moisture-proofness of the film were measured, and the results are shown in Table 3.

Example 9

The adhesive coating liquid B-9 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-14 having a thickness of 68 μm. Glass, encapsulant and the moisture-proof laminated film D-14 were stacked in that order and laminated in vacuum at 150°C for 10 minutes, and then tested in a pressure cooker test. The interlayer strength and the moisture-proofness of the film were measured, and the results are shown in Table 3.

Example 10

The adhesive coating liquid B-6 was applied to the plastic film (C-2) so that the solid content of the coating film could be 6 g/m$^2$, and dried, and the inorganic thin film layer film A was stuck thereto in dry lamination, and then cured at 40°C for 5 days to produce a moisture-proof laminated film D-15 having a thickness of 48 μm. Glass, encapsulant and the moisture-proof laminated film D-15 were stacked in that order and laminated in vacuum at 150°C for 10 minutes, and then tested in a pressure cooker test. The interlayer strength and the moisture-proofness of the film were measured, and the results are shown in Table 3.

Example 11

The adhesive coating liquid B-9 was applied to the plastic film (C-2) so that the solid content of the coating film could be 6 g/m$^2$, and dried, and the inorganic thin film layer film A was stuck thereto in dry lamination, and then cured at 40°C for 5 days to produce a moisture-proof laminated film D-16 having a thickness of 48 μm. Glass, encapsulant and the moisture-proof laminated film D-16 were stacked in that order and laminated in vacuum at 150°C for 10 minutes, and then tested in a pressure cooker test. The interlayer strength and the moisture-proofness of the film were measured, and the results are shown in Table 3.

Comparative Example 5

The adhesive coating liquid B-12 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-17 having a thickness of 68 μm. Glass, encapsulant and the moisture-proof laminated film D-17 were stacked in that order and laminated in vacuum at 150°C for 10 minutes, and then tested in a pressure cooker test. The interlayer strength and the moisture-proofness of the film were measured, and the results are shown in Table 3.

Comparative Example 6

The adhesive coating liquid B-13 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-18 having a thickness of 68 μm. Glass, encapsulant and the moisture-proof laminated film D-18 were stacked in that order and laminated in vacuum at 150°C for 10 minutes, and then tested in a pressure cooker test. The interlayer strength and the moisture-proofness of the film were measured, and the results are shown in Table 3.

Comparative Example 7

The adhesive coating liquid B-12 was applied to the plastic film (C-2) so that the solid content of the coating film could be 6 g/m$^2$, and dried, and the inorganic thin film layer film A was stuck thereto in dry lamination, and then cured at 40°C for 5 days to produce a moisture-proof laminated film D-19 having a thickness of 48 μm. Glass, encapsulant and the moisture-proof laminated film D-19 were stacked in that order and laminated in vacuum at 150°C for 10 minutes, and then tested in a pressure cooker test. The interlayer strength and the moisture-proofness of the film were measured, and the results are shown in Table 3.

Comparative Example 8

The adhesive coating liquid B-13 was applied to the plastic film (C-2) so that the solid content of the coating film could be 6 g/m$^2$, and dried, and the inorganic thin film layer film A was stuck thereto in dry lamination, and then cured at 40°C for 5 days to produce a moisture-proof laminated film D-20 having a thickness of 48 μm. Glass, encapsulant and the moisture-proof laminated film D-20 were stacked in that order and laminated in vacuum at 150°C for 10 minutes, and then tested in a pressure cooker test. The interlayer strength and the moisture-proofness of the film were measured, and the results are shown in Table 3.

Reference Example 1

The adhesive coating liquid B-10 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-21 having a thickness of 68 μm. Glass, encapsulant and the moisture-proof laminated film D-21 were stacked in that order and laminated in vacuum at 150°C for 10 minutes, and then tested in a pressure cooker test. The interlayer strength and the moisture-proofness of the film were measured, and the results are shown in  Table 3.

Reference Example 2

The adhesive coating liquid B-11 was applied to the plastic film (C-1) so that the solid content of the coating film could be 6 g/m$^2$, and dried, and the inorganic thin film layer film A was stuck thereto in dry lamination, and then cured at 40°C for 5 days to produce a moisture-proof laminated film D-22 having a thickness of 68 μm. Glass, encapsulant and the moisture-proof laminated film D-22 were stacked in that order and laminated in vacuum at 150°C for 10 minutes, and then tested in a pressure cooker test. The interlayer strength and the moisture-proofness of the film were measured, and the results are shown in Table 3.

[Table 3]

Table 3

| | Moisture-proof Laminated Film | Plastic Film | Adhesive Coating Liquid | Change of Storage Elastic Modulus of Adhesive layer | | Moisture-proofness | | | Interlayer Strength [N/15 mm] |
| | | | | E21 = (E2-E1)/E2 | E23 = (E2-E3)/E2 | Water Vapor Transmission Rate [g/m$^2$·day] | | Degree of Degradation | |
| | | | | | | Initial | After Pressure Cooker Test | | After Pressure Cooker Test |
| Example 6 | D-11 | C-1 | B-6 | -0.02 | -0.03 | 0.03 | 0.278 | 9 | 9.60 |
| Example 7 | D-12 | C-1 | B-7 | 0.02 | -0.18 | 0.02 | 0.105 | 5 | 8.50 |
| Example 8 | D-13 | C-1 | B-8 | 0.34 | -0.15 | 0.01 | 0.210 | 21 | 5.00 |
| Example 9 | D-14 | C-1 | B-9 | 0.02 | 0.04 | 0.01 | 0.080 | 8 | 7.75 |
| Example 10 | D-15 | C-2 | B-6 | -0.02 | -0.03 | 0.02 | 0.150 | 8 | 8.90 |
| Example 11 | D-16 | C-2 | B-9 | 0.02 | 0.04 | 0.01 | 0.030 | 3 | 7.33 |
| Comparative Example 5 | D-17 | C-1 | B-12 | 1.00 | -0.37 | 0.01 | 0.410 | 41 | 0.65 |
| Comparative Example 6 | D-18 | C-1 | B-13 | 0.80 | 0.77 | 0.01 | 0.360 | 36 | 4.45 |
| Comparative Example 7 | D-19 | C-2 | B-12 | 1.00 | -0.37 | 0.01 | 0.360 | 36 | 0.43 |

(continued)

| | Moisture-proof Laminated Film | Plastic Film | Adhesive Coating Liquid | Change of Storage Elastic Modulus of Adhesive layer | | Moisture-proofness | | | Interlayer Strength [N/15 mm] |
|---|---|---|---|---|---|---|---|---|---|
| | | | | E21 = (E2-E1) /E2 | E23 = (E2-E3) /E2 | Water Vapor Transmission Rate [g/m²·day] | | Degree of Degradation | |
| | | | | | | Initial | After Pressure Cooker Test | | After Pressure Cooker Test |
| Comparative Example 8 | D-20 | C-2 | B-13 | 0.80 | 0.77 | 0.01 | 0.270 | 27 | 3.90 |
| Reference Example 1 | D-21 | C-1 | B-10 | -0.10 | 0.89 | 0.01 | 1.020 | 128 | 8.90 |
| Reference Example 2 | D-22 | C-1 | B-11 | 0.03 | 0.35 | 0.02 | 0.220 | 11 | 2.00 |

As in the above, it is obvious that the moisture-proof laminated films of Examples 6 to 11 in which the values E21 and E23 indicating the change of the tensile storage elastic modulus of the polyurethane adhesive each fall within a specific range keep both the interlayer strength and the moisture-proofness thereof good even after the accelerated test of pressure cooker test. In particular, in Examples 6, 7, and 9 to 11 in which the adhesive used had smaller values of E21 and E23, the interlayer strength of the films was extremely excellent and, in addition, the moisture-proofness thereof after high-temperature treatment was also kept good.
On the other hand, it is obvious that, in Comparative Examples in which the change of the tensile storage elastic modulus of the polyurethane adhesive used fell outside the defined range, the moisture-proofness of the films after the pressure cooker test greatly lowered and became insufficient, and the interlayer strength thereof also lowered.

Industrial Applicability

The moisture-proof laminated film of the present invention keeps excellent moisture-proofness and  interlayer strength even after exposed to high temperature conditions, and is therefore useful as a surface protective member such as a front sheet, a back sheet or the like for solar cells.

**Claims**

1.    A moisture-proof laminated film comprising, on the substrate thereof, an inorganic thin film layer and comprising, on the inorganic thin film layer, a plastic film via a polyurethane adhesive satisfying the following requirement (1):

$$(1) \quad -0.1 \leq E21 \leq +0.5$$

(In the above formula, E21 indicates (E2 - E1)/E2; E1 represents the tensile storage elastic modulus of the adhesive at 150°C, at a frequency of 10 Hz and at a strain of 0.1%; E2 represents the tensile storage elastic modulus of the adhesive at 150°C, at a frequency of 10 Hz and at a strain of 0.1% after heat treatment at 150°C for 30 minutes.)

2.    The moisture-proof laminated film according to claim 1, wherein the moisture-proofness degradation level represented by (b - a)/a $\times$ 100 (%), where (a) indicates the initial water vapor transmission rate of the film and (b) indicates the water vapor transmission rate of the film after heat treatment at 150°C for 30 minutes, is at most 100%.

3.    The moisture-proof laminated film according to  claim 1 or 2, wherein the interlayer strength of the film after heat treatment at 150°C for 30 minutes is at least 7.5 N/15 mm.

4. A moisture-proof laminated film comprising, on the substrate thereof, an inorganic thin film layer and comprising, on the inorganic thin film layer, a plastic film via a polyurethane adhesive satisfying the following requirements (1) and (2):

$$(1) \quad -0.1 \leq E21 \leq +0.5$$

$$(2) \quad -0.3 \leq E23 \leq +0.3$$

(In the above formulae, E21 indicates (E2 - E1)/E2; E23 indicates (E2 - E3)/E2; E1 represents the tensile storage elastic modulus of the adhesive at 150°C, at a frequency of 10 Hz and at a strain of 0.1%; E2 represents the tensile storage elastic modulus of the adhesive at 150°C, at a frequency of 10 Hz and at a strain of 0.1% after heat treatment at 150°C for 30 minutes; E3 represents the tensile storage elastic modulus of the adhesive at 150°C, at a frequency of 10 Hz and at a strain of 0.1% after heat treatment at 150°C for 30 minutes followed by a pressure cooker test (condition: 120°C, 32 hours) in accordance with JIS C 60068-2-66).

5. The moisture-proof laminated film according to claim 4, wherein the moisture-proofness degradation level represented by (c)/(a), where (a) indicates the initial water vapor transmission rate of the film and (c) indicates the water vapor transmission rate of the film after heat treatment at 150°C for 30 minutes followed by a pressure cooker test, is at most 15 times.

6. The moisture-proof laminated film according to claim 4 or 5, wherein the interlayer strength of the film after heat treatment at 150°C for 30 minutes followed by a pressure cooker test is at least 7.0 N/15 mm.

7. The moisture-proof laminated film according to any of claims 1 to 6, wherein the main ingredient of the polyurethane adhesive contains at least one selected from polycarbonate polyols, polyether polyols and polyurethane polyols in an amount of from 20 to 70% by mass.

8. The moisture-proof laminated film according to any of claims 1 to 7, wherein the initial moisture-proofness in terms of the water vapor transmission rate of the film is less than 0.1 $g/m^2 \cdot day$.

9. The moisture-proof laminated film according to any of claims 1 to 8, wherein the initial moisture-proofness in terms of the water vapor transmission rate of the film is at most 0.05 $g/m^2 \cdot day$.

10. The moisture-proof laminated film according to any of claims 1 to 9, wherein the plastic film is at least one selected from polyester films, acrylic films and polycarbonate films.

11. The moisture-proof laminated film according to any of claims 1 to 9, wherein the plastic film is a film formed of a mixture of a polyester resin and an UV absorbent.

12. The moisture-proof laminated film according to any of claims 1 to 9, wherein the plastic film is a fluororesin film.

13. The moisture-proof laminated film according to any of claims 1 to 12, wherein the substrate is a polyester film.

14. The moisture-proof laminated film according to any of claims 1 to 13, wherein the film is used in solar cell surface protective members.

15. A solar cell module comprising the moisture-proof laminated film of any of claims 1 to 13.

## INTERNATIONAL SEARCH REPORT

| International application No. |
|---|
| PCT/JP2011/080471 |

### A. CLASSIFICATION OF SUBJECT MATTER
*B32B27/00*(2006.01)i

According to International Patent Classification (IPC) or to both national classification and IPC

### B. FIELDS SEARCHED

Minimum documentation searched (classification system followed by classification symbols)
B32B1/00-43/00, H01L31/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
WPI

### C. DOCUMENTS CONSIDERED TO BE RELEVANT

| Category* | Citation of document, with indication, where appropriate, of the relevant passages | Relevant to claim No. |
|---|---|---|
| A | WO 2005/092607 A1 (Mitsubishi Plastics, Inc.), 06 October 2005 (06.10.2005), entire text & JP 2005-271467 A & JP 2006-68967 A & US 2007/0224402 A1 & EP 1728622 A1 | 1-15 |
| A | WO 2010/005029 A1 (Mitsubishi Plastics, Inc.), 14 January 2010 (14.01.2010), entire text & EP 2315259 A1 & EP 2315260 A1 & WO 2010/005030 A1 | 1-15 |
| A | JP 10-58586 A (Toyobo Co., Ltd.), 03 March 1998 (03.03.1998), entire text (Family: none) | 1-15 |

☒ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 29 February, 2012 (29.02.12) | 03 April, 2012 (03.04.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/080471

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2003-49004 A  (Mitsubishi Plastics, Inc.),<br>21 February 2003 (21.02.2003),<br>entire text<br>(Family: none) | 1-15 |
| A | WO 2006/095762 A1  (Du Pont-Mitsui<br>Polychemicals Co., Ltd.),<br>14 September 2006 (14.09.2006),<br>entire text<br>& US 2009/0120489 A1    & EP 1863098 A1 | 1-15 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009188072 A
- JP 2009049252 A

- JP 10130615 A